# EUROPÄISCHE PATENTSCHRIFT

(11) **EP 1 736 723 B1**
(45) Veröffentlichungstag und Bekanntmachung des Hinweises auf die Patenterteilung: **16.03.2011**
(21) Anmeldenummer: 06012464.1
(22) Anmeldetag: 17.06.2006
(51) Int. Cl.: F25D 19/00, F17C 3/00

(54) **Kryostatanordnung mit Kryokühler**
Cryostatic device with cryocooler
Dispositif de cryostat avec cryorefroidisseur

(30) Priorität: 23.06.2005 DE 102005029151
(43) Veröffentlichungstag der Anmeldung: 27.12.2006
(73) Patentinhaber: Bruker BioSpin AG, 8117 Fällanden (CH)
(72) Erfinder: Bösel, Johannes, 6345 Neuheim (CH); Meier, Urs, 8620 Wetzikon (CH); Kraus, Andreas, 8616 Riedikon (CH); Mraz, Beat, 8608 Bubikon (CH)
(74) Vertreter: Kohler Schmid Möbus

(56) Entgegenhaltungen:
- EP-A- 0 720 024
- EP-A- 0 955 555
- US-A- 5 782 095

## Beschreibung

Die Erfindung betrifft eine Kryostatanordnung zur Aufbewahrung von kryogenen Fluiden in mindestens einem Kryobehälter, mit einem Außenmantel, einem Strahlungsschild und einem Halsrohr, in das ein Kaltkopf eines Kryokühlers eingebaut ist, wobei mindestens die kälteste Kältestufe des Kaltkopfs des Kryokühlers kontaktfrei bezüglich des Halsrohrs und des Kryobehälters angeordnet ist, und wobei sich im Halsrohr ein kryogenes Fluid befindet.

Eine derartige Kryostatanordnung ist bereits aus der Druckschrift US 2002/0002830 A1 bekannt

Bei Kryostatanordnungen zur Aufbewahrung von kryogenen Fluiden in flüssiger Form, wie sie zum Beispiel bei Messeinrichtungen zur Kernspinresonanz (NMR) Verwendung finden, ist ein supraleitendes Magnetspulensystem in einem ersten Behälter mit flüssigem kryogenen Fluid, gewöhnlicherweise flüssigem Helium, angeordnet, welcher von Strahlungsschilden, Superisolationsfolien und gegebenenfalls einem weiteren Behälter mit flüssigem kryogenen Fluid, gewöhnlicherweise flüssigem Stickstoff, umgeben ist. Die Flüssigkeitsbehälter, Strahlungsschilde und Superisolationsfolien sind in einem äußeren Behälter untergebracht, welcher einen Vakuumraum begrenzt (=Außenmantel, äußere Vakuumhülle). Der supraleitende Magnet wird durch das verdampfende, ihn umgebende Helium auf einer konstanten Temperatur gehalten. Die den ersten Kryobehälter umgebenden Elemente dienen der Wärmeisolierung des Behälters, so dass der Wärmeeinfall auf den Behälter minimiert wird und die Abdampfrate des Heliums klein bleibt.

Magnetsysteme zur hochauflösenden NMR-Spektroskopie sind in der Regel so genannte Vertikalsysteme, bei denen die Achse der Spulenanordnung und die Öffnung zur Aufnahme der NMR-Probe in vertikaler Richtung verlaufen. Der Heliumbehälter ist für NMR-Spektrometer gewöhnlicherweise an mindestens zwei dünnwandigen Aufhängerohren mit der äußeren Vakuumhülle verbunden. Zum einen wird der Behälter somit mechanisch fixiert, zum anderen bieten die Aufhängerohre Zugang zum Magneten, wie es z. B. beim Abkühlen und Laden notwendig ist. Zudem wird das Verlustgas über die Aufhängerohre abgeführt, wodurch die Aufhängerohre gekühlt werden und im Idealfall der Wärmeeintrag über die Rohrwand komplett kompensiert wird. Ein derartiges System wird beispielsweise in den Druckschriften DE 29 06 060 A1 und ,Süperconducting NMR Magnet Design' (Concepts in Magnetic Resonance, 1993, 6, 255-273) beschrieben.

Jedoch ist die Handhabung der Kryogene nicht ganz einfach. Ferner müssen diese in bestimmten Zeitabständen nachgefüllt werden, woraus oft eine unerwünschte Unterbrechung der Messungen entsteht. Die Abhängigkeit von flüssigen Kryogenen ist zudem dort problematisch, wo keine optimale Infrastruktur hierfür vorhanden ist, wie z.B. in Schwellenländern (Indien, China, etc.). Auch eine zukünftige Verteuerung der Kryogene könnte eine solche Kühlung recht kostspielig machen.

Neuerdings werden daher auch vermehrt mechanische Kühlapparate, so genannte Kryokühler, zur direkten Kühlung von supraleitenden Magnetsystemen eingesetzt. Neben der Kühlung ohne kryogene Fluide, der so genannten trockenen Kühlung, sind Systeme bekannt, bei denen mindestens ein weiteres kryogenes Fluid vorhanden ist, welches jedoch nach dem Verdampfen vom Kryokühler wieder verflüssigt wird. Dadurch treten nach außen keine oder nahezu keine Verluste an kryogenen Fluiden auf. Möglichkeiten einer derartigen kryogenverlustfreien Kühlung eines supraleitenden Magnetsystems mit einem Kryokühler werden zum Beispiel in den Druckschriften EP 0 905 436, EP 0 905 524, WO 03/036207, WO 03/036190, US 5 966 944, US 5 563 566, US 5 613 367, US 5 782 095, US 5 918 470, US 2002/0002830, und US 2003/ 230089 beschrieben.

Der beispielsweise zweistufige Kaltkopf des Kryokühlers kann in einem separaten Vakuumraum (wie z.B. in US 5 613 367 beschrieben) oder direkt in den Vakuumraum des Kryostaten (wie z.B. in US 5 563 566 beschrieben) so eingebaut werden, dass die erste Kältestufe des Kaltkopfs fest mit einem Strahlungsschild und die zweite (kältere) Kältestufe über eine feste Wärmebrücke oder direkt mit dem Kryobehälter thermisch leitend verbunden werden. Durch Rückkondensation des durch Wärmeeinfall von außen verdampfenden Heliums an der kalten Kontaktfläche im Kryobehälter kann der gesamte Wärmeeinfall auf den Kryobehälter kompensiert und ein verlustfreier Betrieb des Systems ermöglicht werden. Nachteilig hierbei ist, dass die Verbindung von der zweiten Kältestufe zum Kryobehälter einen thermischen Widerstand aufweist und, selbst bei Verwendung von ,weichen' Elementen zur Wärmeübertragung (z.B. Litzen), Vibrationen des Kryokühlers auf den Kryobehälter und den Magneten übertragen werden können. Gerade für hochauflösende NMR-Systeme können auch kleine Störungen schon problematisch sein, so dass aussagekräftige Messungen nicht mehr möglich werden.

Eine Möglichkeit zur Vermeidung dieser Nachteile ist das Einfügen des Kaltkopfes in ein Halsrohr, welches die äußere Vakuumhülle des Kryostaten mit dem Kryobehälter verbindet und entsprechend mit Heliumgas, also einem kryogenen Fluid in gasförmiger Phase, gefüllt ist, wie es beispielsweise in der Druckschrift US 2002/0002830 beschrieben wird. Die erste Kältestufe des zweistufigen Kaltkopfes ist wiederum fest leitend mit einem Strahlungsschild kontaktiert, die zweite Kältestufe hängt frei in der Helium-Atmosphäre und verflüssigt direkt das verdampfte Helium. Da oft die Kälteleistung des Kryokühlers größer ist als der Wärmeeintrag in den Kryobehälter, wird mit einer zusätzlichen Heizung gerade noch so viel Helium verdampft, dass sich ein stationärer Zustand einstellt. Regelgröße für die Heizung kann beispielsweise der Druck im Kryobehälter sein.

Ein derartiges System hat dann allerdings den Nachteil, dass das Halsrohr nach unten in den Helium-Behälter geöffnet ist. Für einen Service des Kryokühlers muss entweder das Halsrohr unten über eine Spezialvorrichtung geschlossen werden, damit im Fall eines Magnetquenchs keine Gefahr für den Monteur besteht, oder der Magnet muss entladen werden, was eine unerwünschte ,Downtime' des Magnetsystems bedingt. Außerdem treten durch die asymmetrische Öffnung im Normalbetrieb auch asymmetrische Kräfte auf den Helium-Behälter auf, die durch spezielle Zentrierelemente aufgenommen werden müssen. Im Quenchfall wirken zudem größere Kräfte auf die Aufhängerohre. Darüber hinaus ist der Kryokühler dem vollen Quenchdruck ausgesetzt. Aus diesem Grund muss der Kaltkopf mit dem Außenmantel relativ steif verbunden werden, was sich ungünstig auf die Dämpfung von Schwingungen zwischen Kaltkopf und Außenmantel auswirkt. Des Weiteren muss unter Umständen auch das Halsrohr eine vergleichsweise dicke Wandstärke aufweisen, so dass der Wärmeeintrag über das Halsrohr groß wird. Da das Halsrohr und Halsrohreinbauten im Falle eines Magnetquenchs dem erhöhten Quenchdruck ausgesetzt sind, unterliegen auch diese Kryostatenbauteile oft strengeren Richtlinien der Behörden, was einen zusätzlichen Aufwand (z.B. Nachweise der Rückverfolgbarkeit der Bauteile) und höhere Kosten nach sich zieht.

Aufgabe der vorliegenden Erfindung ist es daher, eine einfach aufgebaute Kryostatanordnung mit integriertem Kryokühler vorzuschlagen, bei der die Wärmeübertragung zwischen Kaltkopf des Kühlers und Kryostatanordnung vibrationsarm und effizient stattfindet, und welche im Betrieb eine hohe Sicherheit bietet, speziell auch dann, wenn Wartungsarbeiten vorgenommen werden müssen.

Diese Aufgabe wird erfindungsgemäß dadurch gelöst, dass das Halsrohr zwischen dem Außenmantel der Kryostatanordnung und mindestens einem Kryobehälter und/oder dem Strahlungsschild angeordnet ist, dass das Halsrohr an dem dem Kryobehälter und/oder dem Strahlungsschild zugewandten Ende gasdicht verschlossen ist, dass das Halsrohr an einem der Kryobehälter und/oder einem Strahlungsschild, welches zwischen den Kryobehältern oder zwischen einem Kryobehälter und dem Außenmantel angeordnet ist, über eine gut wärmeleitende Verbindung angekoppelt ist, ,und dass das Halsrohr an dem Ende, welches sich auf Umgebungstemperatur befindet, eine Einfüllvorrichtung zum Einfüllen eines kryogenen Fluids in das Halsrohr aufweist.

Aufgrund des vergleichsweise einfachen Aufbaus besteht kein oder nur ein geringer zusätzlicher Aufwand gegenüber einer Kryostatanordnung ohne Kryokühler, um speziell im Falle eines Magnetquenchs die zusätzlichen mechanischen Belastungen zu tragen und die hohen Sicherheitsanforderungen und Behördenvorgaben zu erfüllen.

Das Halsrohr, in dem sich der Kaltkopf des zur Kühlung verwendeten Kryokühlers befindet, ist vom Kryobehälter gasdicht abgetrennt, so dass sich das Halsrohr in einer eigenen Kryogenatmosphäre befindet. Der Kryogenbereich um den Kryokühler ist daher komplett vom Kryobehälter getrennt. Die Wärmeübertragung vom Kaltkopf zum Kryobehälter erfolgt indirekt über das im Halsrohr befindliche Kryogen (durch Verdampfen und Kondensation eines Teiles des im Halsrohr befindlichen flüssigen Kryogens), ohne dass sich der Kaltkopf des Kryokühlers und der Kryobehälter berühren. Vibrationen des Kaltkopfes werden somit nicht auf den Kryobehälter und die Magnetanordnung übertragen.

Da bei der erfindungsgemäßen Kryostatanordnung keine direkte Öffnung zwischen dem Ende des Halsrohres und dem Kryobehälter, z.B. dem Heliumbehälter, vorhanden ist, wirken im Falle eines Magnetquenchs die durch den Quench freigesetzten Kräfte nicht auf den Kryokühler. Dies hat zur Folge, dass ein sicherer Aus- oder Einbau des Kaltkopfes möglich ist, ohne den Betrieb des in der Kryostatanordnung befindlichen Systems zu unterbrechen. Der Kryobehälter hat dann - abgesehen von den Aufhängerohren - nach außen keine Öffnung. Da im Falle eines Quenchs keine größeren Kräfte auf den Kaltkopf wirken als im Normalbetrieb, abgesehen von einer rein statischen Kraft durch den gegenüber dem Umgebungsdruck leicht erhöhten Innendruck, kann die Verbindung zwischen Kaltkopf und Außenmantel weniger steif ausgeführt werden als für den Fall eines zum Kryobehälter offenen Halsrohres. Die erfindungsgemäße Kryostatanordnung ermöglicht daher unter Umständen auch eine schwingungsgedämpfte, weichere Lagerung auf dem Außenmantel und/ oder die Verwendung einer dünnwandigeren Halsrohrs, was den Wärmeeintrag in den Kryobehälter verkleinert. Ferner fallen das Halsrohr und weitere Halsrohreinbauten nicht mehr unter die strengeren Richtlinien und Sicherheitsvorschriften für Druckbehälter der Behörden, so dass eine kostengünstigere Herstellung möglich wird.

Vorzugsweise befindet sich im Halsrohr das gleiche kryogene Fluid wie im Kryobehälter. Dies ist insbesondere dann relevant, wenn das Halsrohr wärmeleitend mit dem Kryobehälter und nicht ausschließlich mit dem Strahlungsschild verbunden ist. Die Kryogenatmosphäre im Halsrohr kann dann durch den Kryogenvorrat im Kryobehälter gespeist werden, wie weiter unten beschrieben.

Alternativ dazu können sich im Halsrohr und im Kryobehälter unterschiedliche kryogene Fluide befinden. Dies ist möglich, wenn das Halsrohr wärmeleitend ausschließlich mit dem Strahlungsschild verbunden ist oder das kryogene Fluid im Halsrohr bei gleichem Druck einen tieferen Siedepunkt als das kryogene Fluid im Kryobehälter aufweist.

Es ist vorteilhaft, wenn das Halsrohr aus einem Material von geringer thermischer Leitfähigkeit, vergleichbar mit der von rostfreiem Stahl, besteht. Auf diese Weise kann der Wärmeeintrag auf den Kryobehälter verkleinert werden. Außerdem kann aufgrund der kleineren Belastung im Quenchfall die Wandstärke des Halsrohres unter Umständen dünner gewählt werden als für den Fall eines zum Kryobehälter offenen Halsrohrs, was wiederum den Wärmeeintrag reduziert.

Bei einer speziellen Ausführungsform der Erfindung ist das Halsrohr zumindest abschnittweise als Balg ausgebildet. Das Halsrohr kann sich dadurch einer Ausdehnung oder Kontraktion des Kryobehälters anpassen. Zudem wird die vom warmen zum kalten Ende des Halsrohres geleitete Wärme kleiner als für den Fall eines geraden Rohres.

Eine bevorzugte Ausführungsform der erfindungsgemäßen Kryostatanordnung sieht vor, dass das geschlossene Ende des Halsrohrs den Kryobehälter oder den Strahlungsschild direkt kontaktiert. Die Wärmeübertragung erfolgt dann vom Kryobehälter bzw. Strahlungsschild zu dem im Halsrohr befindliche Kryogen nur über eine Trennwand, die das Halsrohr vom Kryobehälter bzw. vom Strahlungsschild trennt.

Der Wärmewiderstand zwischen Halsrohr und Kryobehälter oder Strahlungsschild ist dabei kleiner als 0.05 K/W, vorzugsweise kleiner als 0.01 K/W. Um dieser Forderung zu entsprechen, muss die Fläche der Trennwand entsprechend groß bzw. die Dicke der Trennwand entsprechend klein und ein die Wärme gut leitendes Material für die Trennwand gewählt werden.

Alternativ dazu kann das geschlossene Ende des Halsrohrs den Kryobehälter oder den Strahlungsschild nicht direkt kontaktieren, sondern mit diesem über starre oder flexible, die Wärme gut leitende Elemente verbunden sein. Dazu können beispielsweise zu Litzen verflochtene Kupferdrähte dienen. In diesem Fall ist der Wärmewiderstand zwischen Halsrohr und Kryobehälter zwar größer als bei einer direkten Verbindung über eine Trennwand, jedoch werden Vibrationen zwischen Halsrohr und Kryobehälter schlechter übertragen. Außerdem tritt dann selbst im Normalbetrieb keine zusätzliche asymmetrische Belastung auf den Kryobehälter auf wie es bei einer direkten Kontaktierung zwischen Halsrohr und Kryobehälter der Fall ist. Zentrierelemente in Form von Zug- oder Druckzentrierungen, die den Kryobehälter in seiner zentralen Lage positionieren, sind somit gleichmäßig belastet und können wie in Kryostatanordnungen ohne ein zusätzliches Halsrohr ausgelegt werden.

Der Wärmewiderstand zwischen Halsrohr und Kryobehälter oder Strahlungsschild ist in diesem Fall kleiner als 0.1 K/W, vorzugsweise kleiner als 0.05 K/W. Litzenanzahl, -länge, -durchmesser und -material müssen entsprechend gewählt werden.

Eine vorteilhafte Ausführungsform der erfindungsgemäßen Kryostatanordnung sieht vor, dass das Halsrohr über die Einfüllvorrichtung mit einem externen Reservoir eines kryogenen Fluids verbunden ist. Auf diese Weise kann während des Abkühlens der Kryostatanordnung dem Halsrohr immer wieder kryogenes Fluid zugeführt werden. Hierbei kann das kryogene Fluid auch als (Hochdruck-)Gas bei Raumtemperatur vorliegen und mit einem Druckreduzierventil permanent, also auch nach dem Abkühlen, mit dem Halsrohr verbunden sein, so dass selbst bei einem Leck im Halsrohrbereich und dem damit verbundenen Gasverlust nach außen immer wieder Gas aus dem externen Reservoir nachströmen kann.

Besonders bevorzugt ist eine Ausführungsform, bei der der Kryobehälter an mindestens einem Aufhängerohr aufgehängt ist, welches mit dem Außenmantel der Kryostatanordnung verbunden ist, wobei der Außenmantel, der oder die Kryobehälter, das Halsrohr und das mindestens eine Aufhängerohr einen evakuierten Raum begrenzen, und wobei das Halsrohr mit mindestens einem Aufhängerohr des Kryobehälters über eine absperrbare Verbindungsleitung verbunden ist, in welcher ein Schnellschlussventil integriert ist. Über das Aufhängerohr und die absperrbare Verbindungsleitung kann während der Abkühlphase der Kryostatanordnung Kryogen vom Kryobehälter in das Halsrohr geführt werden. Das aus dem Aufhängerohr bei Umgebungstemperatur als Gas austretende Kryogen wird dabei an der Halsrohrwand und/ oder den Rohren des Kaltkopfes des Kühlers wieder abgekühlt und in der Endphase der Abkühlphase am unteren Ende von Halsrohr bzw. Kaltkopf sogar verflüssigt. Das Schnellverschlussventil dient dazu, im Falle eines Quenchs der Magnetanordnung bei offenem Absperrventil und des damit verbunden Druckanstiegs im Kryobehälter, zu verhindern, dass auch im Bereich des Halsrohrs der Druck steigt. Sobald eine größere Menge an (Quench-)-Gas durch die Verbindungsleitung fließt, schließt das Schnellschlussventil automatisch, so dass das Halsrohr vom Kryobehälter entkoppelt ist. Der Druck im Bereich des Halsrohrs bleibt in diesem Fall annähernd gleich. Somit fallen das Halsrohr und weitere Halsrohreinbauten nicht mehr unter die strengeren Richtlinien und Sicherheitsvorschriften für Druckbehälter der Behörden, so dass eine kostengünstigere Herstellung möglich wird. Auch Montagearbeiten am Kühler und Halsrohr sind bei geladenem Magnet möglich, ohne dass im Quenchfall eine Gefahr für den Monteur besteht.

Darüber hinaus kann mindestens ein Aufhängerohr des Kryobehälters, der mit dem Halsrohr wärmeleitend verbunden ist, zusätzlich mit einer weiteren Leitung oder ausschließlich mit der weiteren Leitung verbunden sein, die mit dem Halsrohr thermisch kontaktiert ist und in den Kryobehälter mündet, wobei in der weiteren Leitung eine Absperrarmatur und/oder eine Pumpe eingefügt sein kann. Die weitere Leitung verbindet demnach den Kryobehälter nicht mit dem Inneren des Halsrohrs, sondern wird lediglich an diesem vorbei geführt. Somit bildet sich eine Gasströmung durch das Aufhängerohr und die weitere Leitung zurück in den Kryobehälter aus. Das aufsteigende Gas nimmt dabei Wärme von der Wand des Aufhängerohrs auf, kühlt dieses, und wird in der weiteren Leitung in dem Bereich wieder abgekühlt, wo diese mit dem Halsrohr verbunden ist. Somit reduziert sich die auf den Kryobehälter über das oder die Aufhängerohr(e) einfallende Wärme.

Eine alternative Ausführungsform der erfindungsgemäßen Kryostatanordnung sieht vor, dass der Kryobehälters über mindestens eine Fluidleitung, die durch den Außenmantel der Kryostatanordnung geführt ist, mit dem sich auf Umgebungstemperatur befindenden Ende des Halsrohrs verbunden ist, wobei der Außenmantel, der mindestens eine Kryobehälter, das Halsrohr und die mindestens eine Fluidleitung einen evakuierten Raum begrenzen, und wobei in die Fluidleitung im Bereich zwischen dem Außenmantel und dem Halsrohr ein Schnellschlussventil und eine Absperrarmatur integriert sind. Mittels dieser Fluidleitung kann somit auch bei Kryostatanordnungen, die nicht an Aufhängerohren aufgehängt sind, Kryogen vom Kryobehälter in das Halsrohr geführt werden.

Bei einer bevorzugten Ausführungsform ist der Kryokühler ein Pulsrohrkühler oder ein Gifford-McMahon Kryokühler mit mindestens zwei Kältestufen. Mittels zweier Kältestufen lassen sich besonders niedrige Temperaturen erzeugen und es lässt sich Kälte auf zwei verschiedenen Temperaturniveaus bereitstellen.

Dabei kann vorzugsweise an einer Kältestufe des Kaltkopfs des Kryokühlers eine Temperatur von 77 K oder eine tiefere Temperatur und gleichzeitig an einer anderen (zweiten) Kältestufe flüssiges Helium bei einer Temperatur von 4,2 K oder bei einer tieferen Temperatur erzeugt werden.

Es ist vorteilhaft, wenn mindestens eine Kältestufe des Kaltkopfs des Kryokühlers, welche nicht die kälteste Kältestufe ist, an einem Strahlungsschild oder einem weiteren Kryobehälter, welcher nicht der kälteste Kryobehälter ist, thermisch angekoppelt ist. Somit wird die auf den Strahlungsschild einfallende Wärme wieder abgeführt oder die Verluste an Kryogen im weiteren Kryobehälter kompensiert bzw. zumindest reduziert.

Diese thermische Ankopplung der mindestens einen Kältestufe an den Strahlungsschild oder den weiteren Kryobehälter ist vorzugsweise eine flexible und/oder starre Festkörperverbindung, welche durch die Halsrohrwand geführt ist. Es ist zum Beispiel vorstellbar, dass die Verbindung zwischen Kältestufe und Halsrohrwand fest und die Verbindung zwischen Halsrohrwand und Strahlungsschild oder weiterem Kryobehälter flexibel in Form von Kupferlitzen ausgeführt wird.

Besonders vorteilhaft ist es, wenn zur thermischen Ankopplung der mindestens einen Kältestufe an den Strahlungsschild oder den weiteren Kryobehälter ein Gasspalt zwischen der mindestens einen Kältestufe des Kaltkopfs des Kryokühlers und der mit der Halsrohrwand verbundenen Festkörperverbindung vorgesehen ist. Somit kann die Übertragung von Vibrationen vom Kaltkopf auf den Strahlungsschild oder den weiteren Kryobehälter minimiert werden, wobei die Wärmeübertragung immer noch gut genug ist. Die Festkörperverbindung kann zudem flexibel oder starr ausgeführt sein.

Der Kryokühler der erfindungsgemäßen Kryostatanordnung kann jedoch auch ein Pulsrohrkühler oder ein Gifford-McMahon Kryokühler mit einer Kältestufe sein.

Vorzugsweise kann an der Kältestufe eine Temperatur von 77 K oder eine tiefere Temperatur erzeugt werden, beispielsweise zur Verflüssigung von Stickstoff. Somit wird die Kühlung eines Kryobehälters mit flüssigem Stickstoff oder eines Strahlungsschilds ermöglicht.

Um einen unnötigen Wärmeeintrag vom Halsrohr in die Rohre des Kaltkopfes des Kryokühlers zu vermeiden, ist es vorteilhaft, wenn die Rohre des Kaltkopfes des Kryokühlers im Bereich zumindest einer Kältestufe zumindest teilweise mit einer Wärmeisolation umgeben sind.

Bei einer bevorzugten Ausführungsform der Erfindung ist in mindestens einem der Kryobehälter eine elektrische Heizung vorgesehen. Hierdurch kann der Druck im Kryobehälter geregelt werden.

Eine solche Regelung kann auch erfolgen, wenn im oder am Halsrohr eine elektrische Heizung vorgesehen ist.

Ebenso kann an mindestens einer Kältestufe des Kryokühlers eine elektrische Heizung vorgesehen sein, welche sich in Kontakt mit dieser Kältestufe befindet. Auch über diese Heizung lässt sich indirekt der Druck im Kryobehälter konstant halten.

Die Vorteile der Erfindung kommen dabei besonders gut zur Geltung, wenn die supraleitende Magnetanordnung Teil einer Apparatur zur Magnetresonanz-Spektroskopie, insbesondere Magnetresonanzbildgebung (MRI) oder Kernmagnetresonanz-Spektroskopie (NMR) ist. Zur Aufnahme von MRI- oder NMR-Daten ist es besonders wichtig Störungen aufgrund von Vibrationen zu vermeiden. Mittels der direkten Kühlung durch den Kryokühler kann ein langer, ununterbrochener Betrieb gewährleistet werden; selbst Wartungs- und Reparaturarbeiten am Kühler sind bei hoher Sicherheit für das Personal möglich, ohne dass der Magnet entladen werden muss und ein längerer Unterbruch entsteht. Der zusätzliche apparative, konstruktive und mit Kosten verbundene Aufwand hält sich dabei in Grenzen.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung einer Kryostatanordnung mit einem zu einem Kryobehälter offenen Halsrohr und einem darin integrierten Kaltkopf eines Kryokühlers gemäß dem Stand der Technik;
- Fig. 2: eine schematische Darstellung einer erfindungsgemäßen Kryostatanordnung mit direktem Kontakt eines geschlossenen Halsrohrs mit dem Kryobehälter und mit geschlossener Verbindungsleitung zwischen einem Aufhängerohr des Kryobehälters und dem Halsrohr;
- Fig. 3: eine schematische Darstellung einer weiteren Ausführungsform einer erfindungsgemäßen Kryostatanordnung mit indirektem Kontakt von Halsrohr und Kryobehälter und mit geschlossener Verbindungsleitung zwischen dem Aufhängerohr des Kryobehälters und dem Halsrohr;
- Fig. 4: eine schematische Darstellung einer erfindungsgemäßen Kryostatanordnung mit offener Verbindungsleitung zwischen dem Aufhängerohr des Kryobehälters und dem Halsrohr;
- Fig. 5: eine schematische Darstellung des Bereich des Halsrohrs und des Temperaturverlaufs im unteren Bereichs des Kryogenbads des Halsrohres einer erfindungsgemäßen Kryostatanordnung bei offener Verbindungsleitung zwischen dem Aufhängerohr des Kryobehälters und dem Halsrohr;
- Fig. 6: eine schematische Darstellung einer erfindungsgemäßen Kryostatanordnung mit einer Verbindungsleitung zwischen dem Aufhängerohr des Kryobehälters und dem Kryobehälter, wobei die Verbindungsleitung mit dem Halsrohr thermisch kontaktiert ist;
- Fig. 7: eine schematische Darstellung einer erfindungsgemäßen Kryostatanordnung während des Abkühlens des Kryobehälters und des Halsrohrs, wobei das Halsrohr mit einem externen Gas-Reservoir eines kryogenen Fluids verbunden ist; und
- Fig. 8: eine schematische Darstellung einer weiteren Ausführungsform einer erfindungsgemäßen Kryostatanordnung zur Kühlung eines Strahlungsschildes.

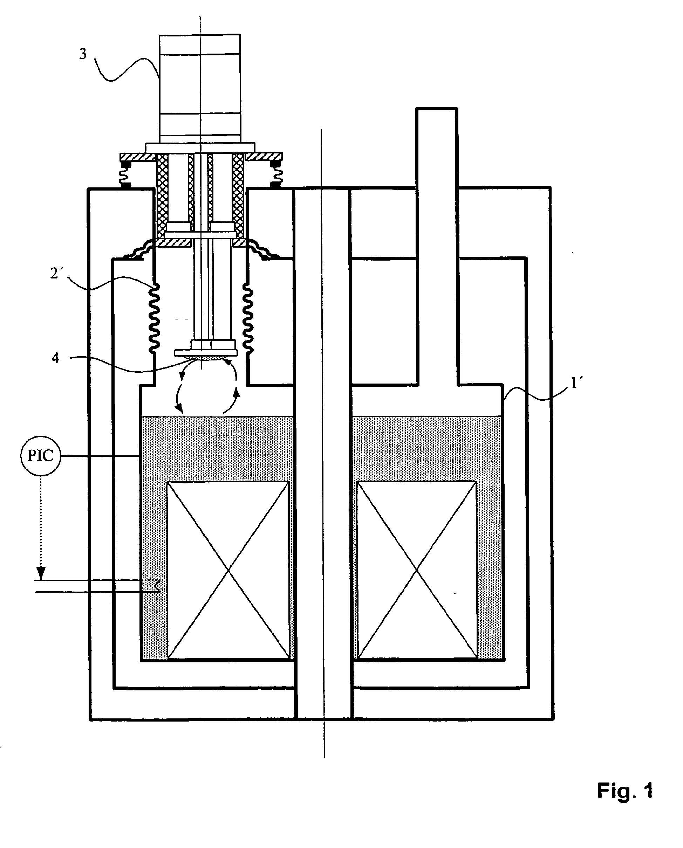

**Fig. 1** zeigt eine Kryostatanordnung mit einer supraleitenden Magnetspule **26** mit einem zu einem Kryobehälter **1'** offenen, teilweise als Balg ausgebildeten Halsrohr **2',** in dem ein zweistufiger Kaltkopf **3** eines Kryokühlers angeordnet ist. Das am Kaltkopf 3 verflüssigte Kryogen **4** tropft direkt in den Kryobehälter 1', von wo durch Wärmeeintrag auf den Kryobehälter 1' verdampfendes Kryogen in das Halsrohr 2' steigt, um dort wieder vom Kaltkopf 3 verflüssigt zu werden. Im Falle eines Magnetquenchs steigt sowohl im Kryobehälter 1' als auch im Halsrohr 2' der Druck schnell an, so dass ein gefahrloser Ein- bzw. Ausbau des Kaltkopfes 3 im Betrieb der Kryostatanordnung nicht garantiert werden kann. Da auch das Halsrohr 2' im Quenchfall dem erhöhten Druck ausgesetzt wird, muss es ferner so ausgelegt werden, dass es die hohen mechanischen Belastungen während eines Quenchs erträgt. Zudem kommen für das Halsrohr 2' und weitere Halsrohreinbauten strengere Richtlinien und Sicherheitsvorschriften der Behörden zur Anwendung.

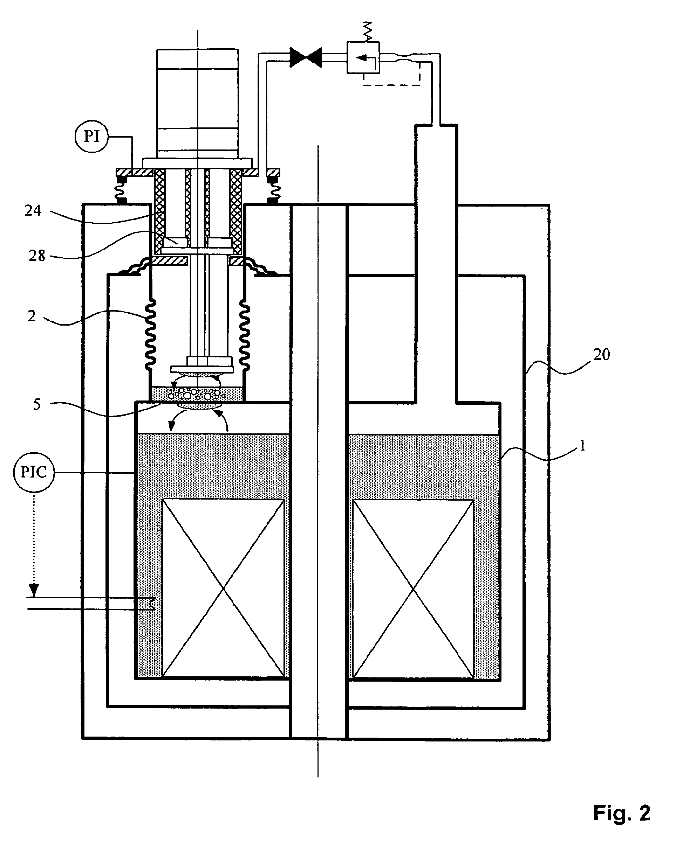

In **Fig. 2** ist eine Ausführungsform der erfindungsgemäßen Kryostatanordnung mit einer supraleitenden Magnetspule 26 dargestellt, bei der ein Kryobehälter **1** gasdicht von einem Halsrohr **2** abgetrennt ist. Das Halsrohr 2 steht jedoch über eine Trennwand **5** in direkten thermischen Kontakt mit dem Kryobehälter 1.

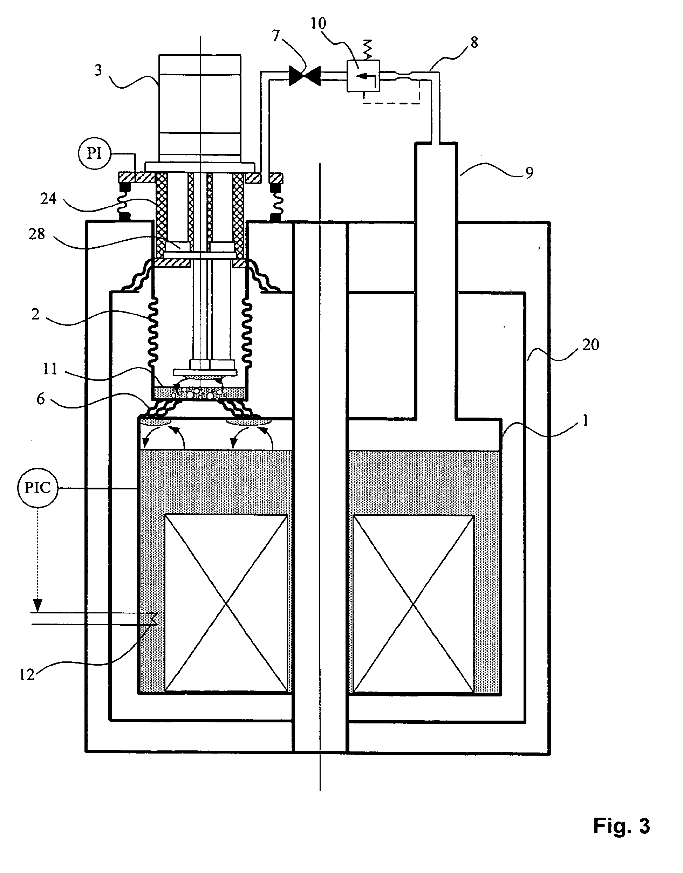

**Fig. 3** zeigt eine alternative Ausführungsform, bei der der thermische Kontakt vom Halsrohr 2 zum Kryobehälter 1 indirekt über flexible, die Wärme gut leitende Elemente **6** erfolgt. Beide Ausführungsformen weisen eine durch ein Absperrventil **7** absperrbare Verbindungsleitung **8** auf, die ein Aufhängerohr **9** der Kryostatanordnung mit dem Halsrohr 2 verbindet. In der Verbindungsleitung 8 ist ein Schnellschlussventil **10** integriert, welches dazu dient, dass bei offenem Absperrventil 7 im Falle eines Magnetquenchs der Druck nicht auch im Bereich des Halsrohrs 2 steigt. Somit fällt das Halsrohr 2 nicht mehr unter die strengeren Richtlinien und Sicherheitsvorschriften für Druckbehälter der Behörden, was eine kostengünstigere Herstellung ermöglicht. Auch Montagearbeiten am Kaltkopf 3 des Kühlers und Halsrohr 2 sind bei geladener Magnetspule 26 und offenem Absperrventil 7 möglich, ohne dass im Quenchfall eine Gefahr für den Monteur besteht. In einem Schnellschlussventil 10 ist gewöhnlich eine Drosselstelle integriert, über die beim plötzlichen Auftreten eines erhöhten Gasstroms ein Druckabfall auftritt, der bewirkt, dass das Ventil gegen eine (einstellbare) Feder schließt.

Das System ist selbstregulierend. Zu Beginn ist das Absperrventil 7 in der Verbindungsleitung 8 zwischen dem Kryobehälter 1 und dem Halsrohr 2 offen. Im Halsrohr 2 und im Kryobehälter 1 herrscht somit der gleiche Druck. Beim Abkühlen der Kryostatanordnung wird während und nach dem Befüllen des Kryobehälters 1 mit kryogener Flüssigkeit bei eingeschaltetem Kryokühler dem Halsrohr 2 immer wieder Kryogen aus dem Kryobehälter 1 zugeführt. Ist das untere Ende des Halsrohres 2 und des Kaltkopfs 3 des Kryokühlers kalt genug und zudem die Kälteleistung des Kryokühlers größer als der Wärmeeinfall auf den Kryobehälter 1 und auf das Halsrohrs 2, beginnt der Kaltkopf 3 Kryogen zu verflüssigen, welches sich im unteren Bereich des Halsrohrs 2 als Kryogenbad 11 ansammelt. Im weiteren Verlauf saugt der Kryokühler immer mehr Kryogen aus dem Kryobehälter 1 über die Verbindungsleitung 8 an, so dass der Flüssigkeitsspiegel des Kryogenbads 11 im Halsrohr 2 permanent steigt. Zudem sinkt der Druck sowohl im Halsrohr 2 als auch im Kryobehälter 1, da der Kryokühler mehr Gas verflüssigt als an Flüssigkeit verdampft. Wegen des identischen Drucks im Halsrohr 2 und im Kryobehälter 1 ist auch die Temperatur in beiden Teilbereichen gleich (= die zum vorherrschenden (Dampf-)Druck gehörende Siedetemperatur). Da keine Temperaturdifferenz zwischen dem Kryobehälter und dem Halsrohr besteht, kommt es auch nicht zu einem Wärmestrom zwischen dem Kryobehälter 1 und dem Kryogenbad 11 im Halsrohr 2.

Jetzt wird das Absperrventil 7 in der Verbindungsleitung geschlossen, wie in Fig. 2 und Fig. 3 gezeigt. Der Kaltkopf 3 verflüssigt weiter Kryogen. Da aber kein Kryogen aus dem Kryobehälter 1 nachfließen kann,'sinkt der Druck im Bereich des Halsrohrs 2. Zu dem tieferen Druck im Bereich des Halsrohrs 2 gehört auch eine tiefere Siedetemperatur des Kryogenbads 11, so dass jetzt zwischen dem Kryobehälter und dem Halsrohr eine Temperaturdifferenz auftritt, die zu einem Wärmestrom vom Kryobehälter 1 in das Kryogenbad 11 des Halsrohrs 2 führt. Im Kryobehälter 1 kondensiert verdampftes Kryogen an der etwas kälteren Trennwand 5 (Fig. 2) beziehungsweise an der Wand des Kryobehälters (Fig. 3), und gibt seine Kondensationswärme ab, welche durch die Trennwand 5 (Fig. 2) beziehungsweise über die Wärmegut leitenden Elemente 6 (Fig. 3) fließt und im Kryogenbad 11 des Halsrohres 2 zur Verdampfung von Kryogen führt. Der Kryogendampf steigt dann im Halsrohr 2 auf, wird dort an der zweiten Kältestufe 27 des Kaltkopfes 3 verflüssigt und tropft in das Kryogenbad 11 des Halsrohrs 2 zurück. Somit gibt es zwei getrennte Kryogen-Kreisläufe (Verdampfen und Kondensieren), die miteinander gekoppelt sind, wobei die Wärme zwar über eine vergleichbar große Distanz wie bei einer Kryostatanordnung nach dem Stand der Technik, aber über eine Trennwand 5 beziehungsweise Wärme gut leitende Elemente 6 von einem geschlossenen in ein anderes geschlossenes System mit nur kleiner Temperaturdifferenz übertragen wird, ähnlich wie bei zwei miteinander verbundenen Wärmerohren (heat pipes).

Stellt der Kryokühler mehr Kälteleistung zur Verfügung als für die Kondensation des verdampften Kryogens benötigt wird, wird weiter Gas aus dem Halsrohr 2 verflüssigt, wodurch der Druck dort weiter sinkt. Dies bewirkt wiederum ein Absinken der Temperatur des Kryogenbads 11 im Halsrohr 2, wodurch der Wärmestrom durch die Trennwand 5 beziehungsweise Wärme gut leitende Elemente 6 größer wird und mehr Kryogen aus dem Kryogenbad 11 des Halsrohres 2 verdampft. Umgekehrt kondensiert auch mehr Dampf im Kryobehälter 1, so dass auch hier der Druck sinkt, wenn nicht von außen eingegriffen wird. Die Regelung des Drucks im Kryobehälter 1, vorzugsweise auf einen Wert, der größer ist als der Umgebungsdruck, kann dabei über einen Regler **PIC** erfolgen, der eine Heizung **12** im Kryobehälter 1 so steuert , dass die Überschussleistung des Kryokühlers 1 kompensiert wird und der Druck konstant bleibt. Ein Gleichgewicht kann somit schnell eingestellt werden, wobei dann im Kryogenbad 11 im Halsrohr 2 genauso viel Kryogen verdampft, wie der Kryokühler 1 wieder verflüssigen kann.

Die Temperaturdifferenz und somit auch die Druckdifferenz zwischen dem Kryobehälter 1 und dem Halsrohr 2 hängen von der Güte des Wärmeübergangs, der Größe der wärmeübertragenden Fläche, der Dicke und dem Material der Trennwand 5 ab. Je besser der Wärmeübergang, je größer die wärmeübertragenden Fläche, je dünner und je besser wärmeleitend das Material der Trennwand 5, umso kleiner wird die Temperatur- und Druckdifferenz.

Üblicherweise ist der Wärmewiderstand der flexiblen, die Wärme gut leitenden Elemente 6 gemäß Fig. 3 größer als der der Trennwand 5 gemäß Fig. 2. Damit die Temperatur- und Druckdifferenz zwischen dem Kryobehälter 1 und dem Halsrohr 2 auch in diesem Fall nicht zu groß werden, sollte der Wärmewiderstand der Elemente 6 nicht größer als 0.1 K/W sein. Führt beispielsweise der Kühler an der zweiten Kältestufe 27 einen Wärmestrom von 0.5 W ab, so entsteht zwischen Kryobehälter 1 und Halsrohr 2 eine Temperaturdifferenz von 0.05 K, was wiederum einer Druckdifferenz von etwa 48 mbar entspricht. Wird der Druck im Kryobehälter 1 dann auf 1.04 bar eingeregelt, so liegt der Druck im Halsrohr bei 0.992 bar, was für eine Höhenlage von etwa 500 m.ü.M. in den allermeisten Wetterlagen höher als der Umgebungsdruck ist. Es ist auch zu beachten, dass die Leistung des Kryokühlers mit tiefer werdender Temperatur an der zweiten Kältestufe 27 sinkt, so dass ein kleiner Wärmewiderstand der Trennwand 5 auch aus diesem Grund anzustreben ist.

Die Anordnung gemäß Fig. 3 weist den Vorteil auf, dass selbst im Normalbetrieb keine zusätzliche asymmetrische Belastung auf den Kryobehälter 1 entsteht. Somit können beispielsweise Zentrierelemente, die den Kryobehälter 1 gegenüber dem Außenmantel zentral positionieren, wie in einer konventionellen Kryostatanordnung (ohne direkte Kühlung mit einem Kryokühler) ausgeführt werden.

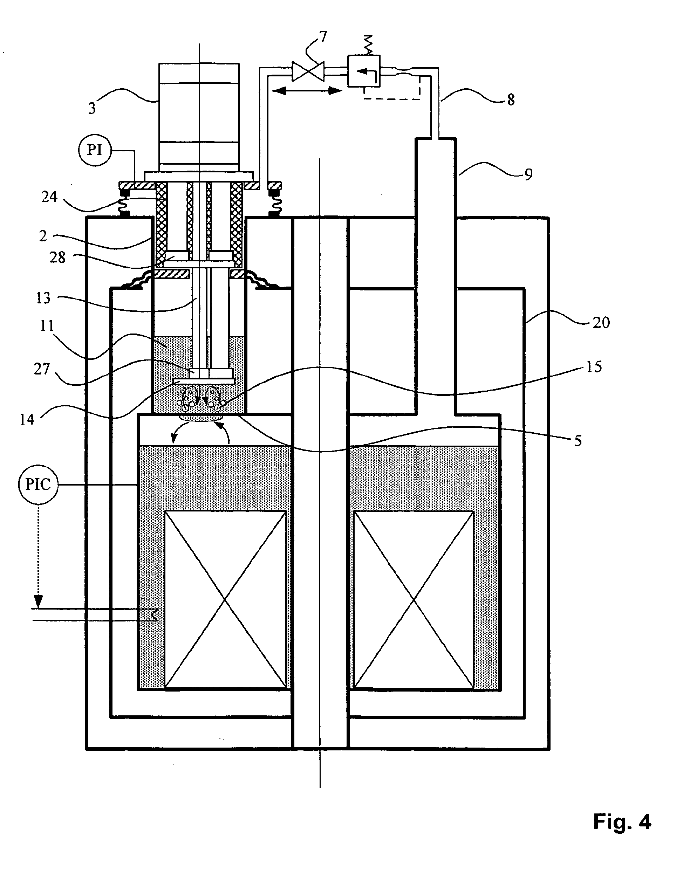

Die vorgeschlagene Anordnung funktioniert auch dann, wenn die Verbindungsleitung 8 zwischen dem Aufhängerohr 9 und dem Halsrohr 2 offen bleibt. Dies ist in **Fig.4** gezeigt. Wird das Absperrventil 7 in der Verbindungsleitung 8 nach dem Abkühlen nämlich nicht geschlossen, so sammelt sich immer mehr flüssiges Kryogen im Kryogenbad 11 im Halsrohr 2 an. Schließlich erreicht der Flüssigkeitsspiegel des Kryogenbads 11 die zweite Kältestufe 27 des Kaltkopfes 3 und steigt um das Puls- und Regeneratorrohr 13 der zweiten Kältestufe 27 des Kaltkopfes 3 an. Der im Halsrohr 2 befindliche Kryogendampf kondensiert jetzt nicht mehr an der zweiten Kältestufe 27 sondern an der Flüssigkeitsoberfläche des Kryogenbads 11.

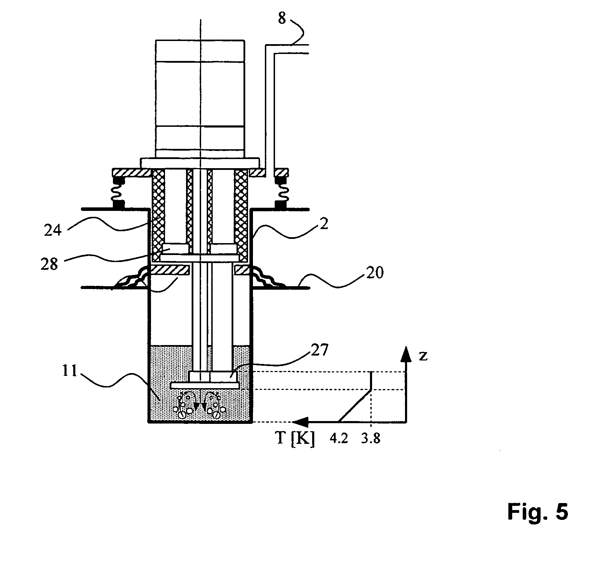

Falls die zweite Kältestufe 27 des Kaltkopfes 3 eine Überschussleistung besitzt, wird ihre Temperatur jetzt unter die zum Druck gehörende Siedetemperatur des Kryogens absinken und die Flüssigkeit im Kryogenbad 11 am Flansch **14** der zweiten Kältestufe 27 wird sich unterkühlen. **Fig. 5** zeigt den Temperaturverlauf im unteren Bereich des Kryogenbads 11 des Halsrohres 2 einer erfindungsgemäßen Kryostatanordnung bei offener Verbindungsleitung 8. Die Unterkühlung des Kryogens am Flansch 14 der zweiten Kältestufe 27 führt dazu, dass die Flüssigkeit aufgrund ihrer höheren Dichte dort absinkt. An der Trennwand 5 zwischen Halsrohr 2 und Kryobehälter 1, deren Temperatur nur leicht unter der im Halsrohr 2 bzw. Kryobehälter 1 zum vorhandenen (Dampf-)Druck gehörenden Gleichgewichtstemperatur liegt, verdampft Flüssigkeit im Halsrohr 2, wodurch Dampfblasen **15** entstehen. Die Dampfblasen 15 steigen nach oben und kommen in den Bereich der kälteren Flüssigkeit und in die Nähe des Flansches 14 der zweiten Kältestufe 27. Hier fallen sie wieder in sich zusammen und geben dabei Kondensationswärme ab. Es bildet sich somit eine teilweise zweiphasige Konvektionsströmung zwischen der Trennwand 5 und dem Flansch 14 der zweiten Kältestufe 27 des Kryokühlers aus.

Zusätzlich wird Wärme durch Wärmeleitung zwischen der Trennwand 5 und der zweiten Kältestufe 27 übertragen. Da flüssiges Kryogen, wie zum Beispiel flüssiges Helium, allerdings eine relativ geringe Wärmeleitfähigkeit besitzt, ist dieser Wärmestrom bei der kleinen Temperaturdifferenz und den üblich großen Austauschflächen und Abständen zwischen der Trennwand 5 und der zweiter Kältestufe 27 in der Regel vernachlässigbar.

Es ist zu beachten, dass bei der tieferen Temperatur der zweiten Kältestufe 27 des Kryokühlers jetzt auch eine geringere Kälteleistung zur Verfügung steht. Außerdem kann sich diese auch wegen der, im Vergleich zu einer Anordnung mit geschlossener Verbindungsleitung 8, veränderten Umgebung (jetzt Flüssigkeit an Stelle von Gas) um die Rohre 13 der zweiten Kältestufe 27 des Kryokühlers verkleinern. Sobald der Wärmeeintrag ins Kryogenbad 11 des Halsrohres 2 über die Trennwand 5 zusammen mit den anderen Beiträgen zum Wärmeeintrag (z.B. über die Wand des Halsrohres 2) so groß ist, wie es der Kälteleistung des Kryokühlers bei der tieferen Temperatur entspricht, ist ein Gleichgewichtszustand erreicht.

Das Betreiben der erfindungsgemäßen Kryostatanordnung mit offener Verbindungsleitung 8, wie in Fig. 4 und 5 gezeigt, hat den Nachteil, dass die bei der Siedetemperatur des Kryogens zur Verfügung stehende Kälteleistung der zweiten Kältestufe 27 des Kryokühlers nicht genutzt werden kann, da die Temperatur der zweiten Kältestufe 27 und somit auch die Kälteleistung des Kryokühlers in der unterkühlten Flüssigkeit tiefer liegt. Ein großer Vorteil dieser Anordnung ist aber, dass selbst bei Auftreten eines Lecks im Bereich des Halsrohrs 2 nach außen immer wieder Kryogen aus dem Kryobehälter 1 nachgeführt wird und somit die Funktionstüchtigkeit der Anordnung noch über lange Zeit bestehen bleibt beziehungsweise kein Unterdruck auftritt. Der nach außen auftretende Kryogenverlust ist in diesem Fall das kleinere, kurzzeitig verkraftbare Übel. Tritt hingegen bei geschlossener Verbindungsleitung (Fig. 2 und 3) ein Leck im Bereich des Halsrohrs 2 nach außen auf, so sinkt der Druck im Bereich des Halsrohrs 2, womit auch die Temperatur im Flüssigkeitsbad 11 des Halsrohrs 2 sinkt. Aufgrund der größeren Temperaturdifferenz über die Trennwand 5 verdampft dann mehr Flüssigkeit im Halsrohr 2 und kondensiert mehr Helium-Dampf an der Trennfläche 5 im Kryobehälter 1.

Schließlich kann es vorkommen, dass das gesamte Flüssigkeitsbad 11 im Halsrohr 2 verdampft ist und sogar ein Unterdruck im Halsrohr 2 auftritt.

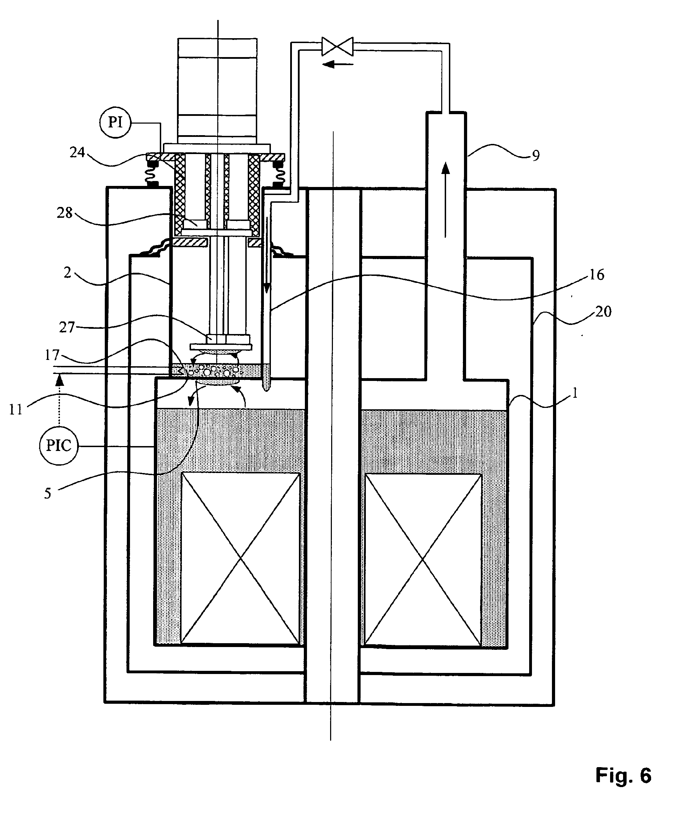

In **Fig. 6** ist eine weitere Ausführungsform der erfindungsgemäßen Kryostatanordnung dargestellt, bei der eine aus dem Aufhängerohr 9 führende weitere Leitung **16** vorgesehen ist, die am Halsrohr 2 entlang in den Kryobehälter 1 geführt ist. Durch diese weitere Leitung 16 wird Kryogen aus dem Kryobehälter 1 über das Aufhängerohr 9 wieder in den Kryobehälter 1 zurückgeführt. Der im Aufhängerohr 9 aufsteigende Kryogendampf nimmt die über die Rohrwand einfallende Wärme auf und erwärmt sich bis auf Umgebungstemperatur beim Austritt aus dem Aufhängerohr 9. Somit wird ein Wärmeeintrag von außen über das Aufhängerohr 9 in den Kryobehälter 1 vermieden. Diese Kühlströmung wird durch die Sogwirkung am mit dem kalten Ende des Halsrohrs 2 verbundenen Ende der weiteren Leitung 16 aufrechterhalten. Fig. 6 zeigt ein bereits mit Kryogen gefülltes Halsrohr 2. Das Befüllen des Halsrohrs 2 kann über eine hier nicht dargestellt Einfüllvorrichtung erfolgen. Es ist beispielsweise vorstellbar, dass eine zusätzliche Verbindungsleitung vorgesehen ist, die über ein weiteres Aufhängerohr (in Fig. 6 nicht gezeigt) eine Versorgung des Halsrohrs 2 mit Kryogen ermöglicht, wie in den Fig. 2 bis 4 dargestellt. Ebenso kann es sich bei der weiteren Leitung 16 um eine verzweigte Leitung handeln, wobei ein Leitungszweig in das Halsrohr 2 mündet und der andere Leitungszweig am Halsrohr 2 vorbeigeführt wird.

Um den Druck im Kryobehälter zu regeln, ist bei der in Fig. 6 gezeigten Ausführungsform eine Heizung **17** im Kryogenbad 11 im Halsrohr 2 vorgesehen. Darüber hinaus ist es auch möglich, dass eine Heizung direkt auf der zweiten Kältestufe 27 des Kryokühlers montiert und dann so angesteuert wird, dass der Druck im Kryobehälter 1 konstant bleibt. Darüber hinaus haben auch die Abmaße und das Material der oben beschriebenen wärmeübertragenden Trennwand 5 zwischen Halsrohr 2 und Kryobehälter 1 einen Einfluss auf den Druck im Halsrohr. Die Trennwand 5 sollte daher groß und dünn und aus einem gut wärmeleitenden Material gewählt werden, so dass der Druck im Halsrohr 2 nicht sehr viel tiefer als im Kryobehälter 1 wird und unter Umständen sogar ein Unterdruck gegen die Umgebung auftritt. Somit wird verhindert, dass bei Auftreten eines Lecks feuchte Luft von außen angesaugt wird und Wasserdampf ausfriert.

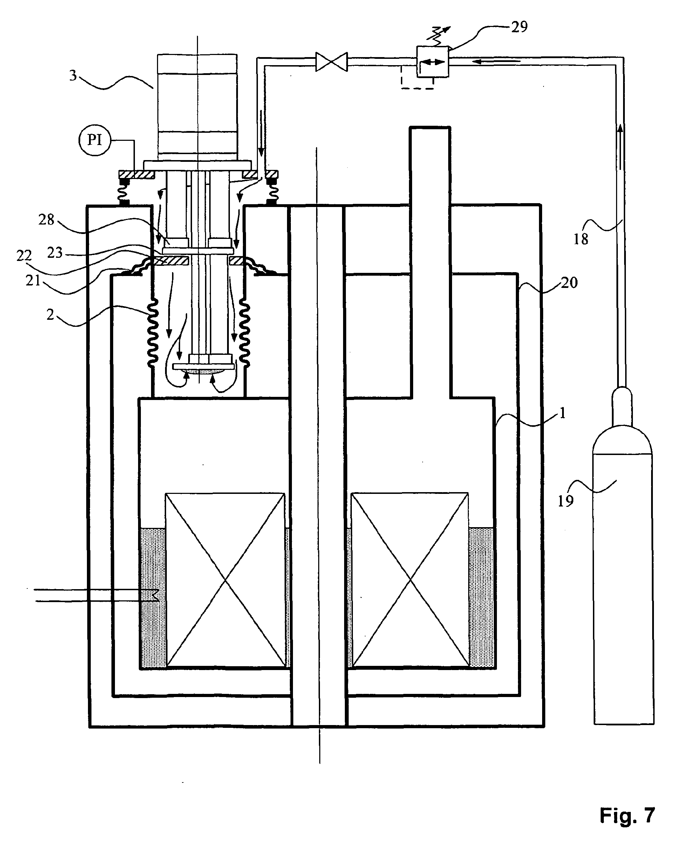

**Fig. 7** zeigt eine erfindungsgemäße Kryostatanordnung während des Abkühlens des Kryobehälter 1 und des Halsrohrs 2. Über eine Zuleitung **18** kann von einem externen Reservoir **19** kryogenes Fluid in das Halsrohr 2 (in Fig. 7 durch Pfeile dargestellt) geleitet werden. Das kryogene Fluid aus dem externen Reservoir 19 tritt gasförmig in das Halsrohr 2 ein und wird entlang der Rohre des Kaltkopfs 3 oder der Wand des Halsrohrs 2 abgekühlt. An der zweiten Kältestufe 27 des Kaltkopfs 3 wird das Kryogen schließlich verflüssigt und tropft auf die Trennwand 5 zwischen dem Halsrohr 2 und dem Kryobehälter 1. Zwischen dem externen Reservoir 19 und dem Halsrohr 2 ist ein Druckreduzierventil 29 integriert. Dieses wird auf einen Druck, der etwas über dem Umgebungsdruck liegt, eingestellt. Ist der Druck im Halsrohr 2 tiefer oder gleich dem eingestellten Druck, so strömt Gas nach. Hat sich nach dem Abkühlen ein stationärer Betriebszustand eingestellt (mit Regelung des Drucks im Kryobehälter 1 und Halsrohr 2 mittels der Heizung 12 im Kryobehälter 1 oder Heizung 17 im Halsrohr 2, so fließt aus dem externen Reservoir 19 kein Gas mehr nach. Bei Auftreten eines Lecks im Halsrohr 1 wird aber auch verhindert, dass im Halsrohr ein Unterdruck entsteht. Das Absinken des (Gas-)Druckes im externen Reservoir 19 unter einen Schwellwert könnte dann beispielsweise einen Alarm im Überwachungssystem der Kryostatanordnung auslösen.

Bei allen gezeigten Ausführungsformen erfolgt der Wärmeübergang zwischen der zweiten Kältestufe 27 des Kryokühlers und dem Kryobehälter 1 vollkommen berührungslos. Eine Übertragung von Vibrationen wird daher weitgehend vermieden.

Bei einem zweistufigen Kryokühler (Fig. 2 bis 7) ist üblicherweise ein Strahlungsschild **20** oder ein weiterer Kryobehälter (beispielsweise mit flüssigem Stickstoff) mit der ersten Kältestufe des Kaltkopfs 3 kontaktiert und somit direkt gekühlt. Die erste Kältestufe kann dabei fest mit dem Strahlungsschild 20 oder (besser) über flexible, die Wärme gut leitende Verbindungselemente **21,** wie beispielsweise Kupferlitzen, verbunden werden. Um die Vibrationsübertragung zwischen der ersten Kältestufe und dem Strahlungsschild 20 jedoch noch effektiver zu unterbinden, kann zum Beispiel zwischen der ersten Kältestufe und einem Kontaktflansch **22,** der dann direkt oder wiederum über flexible, die Wärme gut leitende Verbindungselemente 21 mit dem Strahlungsschild 20 verbunden ist, ein kleiner Gasspalt **23** belassen werden, wie beispielsweise in Fig. 2 und 4 bis 7 gezeigt. Bei genügend großer Kälteleistung auf der ersten Kältestufe fällt dieser zusätzliche Wärmewiderstand dann nicht übermäßig ins Gewicht, so dass die Temperatur des Strahlungsschildes 20 nicht übermäßig steigt.

Um einen unerwünschter Wärmeeintrag von dem Halsrohr 2 in die Rohre 13 des Kaltkopfes zu vermeiden oder zumindest zu reduzieren, sind im Bereich der ersten Kältestufe und unter Umständen auch im Bereich weiterer Kältestufen die Rohre 13 des Kaltkopfes mit einer Wärmeisolation **24** umgeben. Die Rohre oberhalb der ersten Kältestufe des Kaltkopfes weisen Temperaturen zwischen Raumtemperatur und Temperatur der ersten Kältestufe auf.

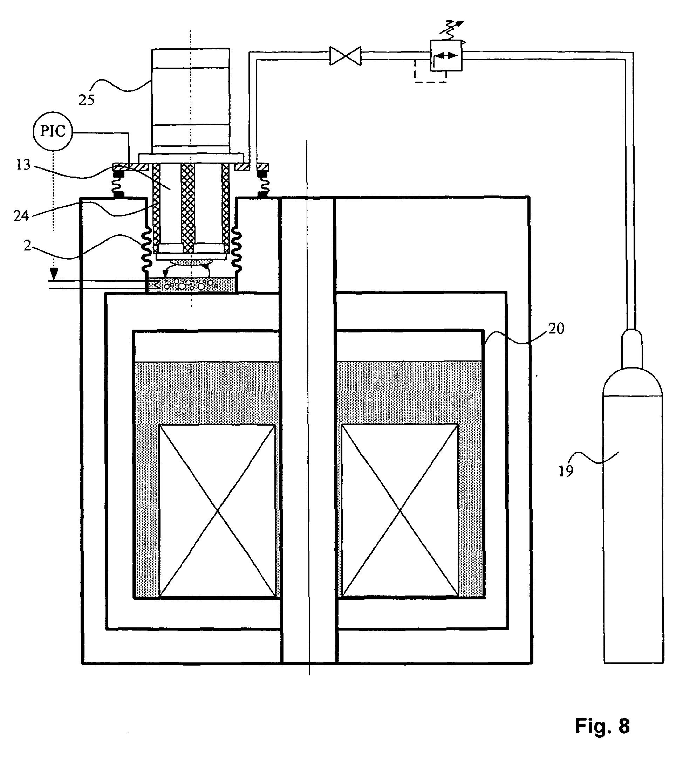

Mit einem einstufigen Kaltkopf **25** kann der Kryobehälter 1 wegen der zu tiefen Temperatur in der Regel nicht gekühlt werden, zum Beispiel dann, wenn er flüssiges Helium enthält. Es ist jedoch vorstellbar, dass entweder ein weiterer Kryobehälter (in den meisten Fällen ein Behälter mit flüssigem Stickstoff) oder ein Strahlungsschild 20 auf analoge Weise, wie oben beschrieben, gekühlt wird. **Fig. 8** zeigt eine solche Ausführungsform. Das Halsrohr 2 wird mit einem passenden Kryogen (z.B. Stickstoff, Argon, Neon) aus einer externen Reservoir 19 befüllt. Wiederum kann es vorteilhaft sein, wenn die Rohre 13 des Kryokühlers im Bereich zwischen Raumtemperatur und der Temperatur der Kältestufe mit einer Wärmeisolation 24 versehen sind. Auch in diesem Fall muss das Halsrohr 2 nicht direkt mit dem Strahlungsschild 20 oder dem weiteren Kryobehälter verbunden sein. Um das Auftreten asymmetrische Kräfte zu verhindern und die Vibrationsübertragung zu erschweren, lassen sich auch hier - wie schon in Fig. 3 gezeigt - flexible, die Wärme gut leitende Elemente 6 verwenden.

### Bezugszeichenliste

- 1': Kryobehälter (Stand der Technik)
- 2': Halsrohr (Stand der Technik)
- 1: Kryobehälter
- 2: Halsrohr
- 3: Kaltkopf
- 4: verflüssigtes Kryogen
- 5: Trennwand
- 6: Wärme gut leitende Elemente
- 7: Absperrventil
- 8: Verbindungsleitung
- 9: Aufhängerohr
- 10: Schnellschlussventil
- 11: Kryogenbad
- 12: Heizung im Kryobehälter
- 13: Rohre des Kaltkopfs
- 14: Flansch der zweiten Kältestufe

- 15: Dampfblasen
- 16: weitere Leitung
- 17: Heizung im Halsrohr
- 18: Zuleitung
- 19: externes Reservoir
- 20: Strahlungsschild
- 21: flexible Verbindungselemente
- 22: Kontaktflansch
- 23: Gasspalt
- 24: Wärmeisolation
- 25: einstufiger Kaltkopf
- 26: Magnetspule
- 27: zweite Kältestufe des Kaltkopfs
- 28: erste Kältestufe des Kaltkopfs
- 29: Druckreduzierventil

## Patentansprüche

1. Kryostatanordnung zur Aufbewahrung von kryogenen Fluiden in mindestens einem Kryobehälter (1'), mit einem Außenmantel, einem Strahlungsschild (20) und einem Halsrohr (2'), in das ein Kaltkopf (3) eines Kryokühlers eingebaut ist, wobei mindestens die kälteste Kältestufe des Kaltkopfs des Kryokühlers kontaktfrei bezüglich des Halsrohrs (2') und des Kryobehälters (1') angeordnet ist, und wobei sich im Halsrohr (2') ein kryogenes Fluid befindet,
**dadurch gekennzeichnet,**
**dass** das Halsrohr (2) zwischen dem Außenmantel der Kryostatanordnung und mindestens einem Kryobehälter (1) und/oder dem Strahlungsschild (20) angeordnet ist, dass das Halsrohr (2) an dem dem Kryobehälter (1) und/oder dem Strahlungsschild (20) zugewandten Ende gasdicht verschlossen ist, dass das Halsrohr (2) an einem der Kryobehälter (1) und/oder dem Strahlungsschild (20), welches zwischen den Kryobehältern (1) oder zwischen einem Kryobehälter (1) und dem Außenmantel angeordnet ist, über eine gut wärmeleitende Verbindung angekoppelt ist, und dass das Halsrohr (2) an dem Ende, welches sich auf Umgebungstemperatur befindet, eine Einfüllvorrichtung zum Einfüllen eines kryogenen Fluids in das Halsrohr (2) aufweist.

2. Kryostatanordnung nach Anspruch 1, **dadurch gekennzeichnet, dass** in einem der Kryobehälter (1) eine supraleitende Magnetanordnung angeordnet ist.

3. Kryostatanordnung, nach einem der vorhergehenden Ansprüche, **dadurch gekennzeichnet, dass** sich im Halsrohr (2) das gleiche kryogene Fluid wie im Kryobehälter (1) befindet.

4. Kryostatanordnung nach Anspruch 1 oder 2, **dadurch gekennzeichnet, dass** sich im Halsrohr (2) und im Kryobehälter (1) unterschiedliche kryogene Fluide befinden.

5. Kryostatanordnung nach einem der vorhergehenden Ansprüche, **dadurch gekennzeichnet, dass** das geschlossene Ende des Halsrohrs (2) den Kryobehälter (1) oder den Strahlungsschild (20) direkt kontaktiert.

6. Kryostatanordnung nach einem der Ansprüche 1 bis 4, **dadurch gekennzeichnet, dass** das geschlossene Ende des Halsrohrs (2) den Kryobehälter (1) oder den Strahlungsschild (20) nicht direkt kontaktiert, sondern mit diesem über starre oder flexible, die Wärme gut leitende Elemente (6) verbunden ist.

7. Kryostatanordnung nach einem der vorhergehenden Ansprüche, **dadurch gekennzeichnet, dass** das Halsrohr (2) über die Einfüllvorrichtung mit einem externen Reservoir (19) eines kryogenen Fluids verbunden ist.

8. Kryostatanordnung nach einem der vorhergehenden Ansprüche, **dadurch gekennzeichnet, dass** der Kryobehälter (1) an mindestens einem Aufhängerohr (9) aufgehängt ist, welches mit dem Außenmantel der Kryostatanordnung verbunden ist, wobei der Außenmantel, der oder die Kryobehälter (1), das mindestens eine Aufhängerohr (9) und das Halsrohr (2) einen evakuierten Raum begrenzen, und wobei das Halsrohr (2) mit mindestens einem Aufhängerohr (9) des Kryobehälters (1) über eine absperrbare Verbindungsleitung (8) verbunden ist, in welcher ein Schnellschlussventil (10) integriert ist.

9. Kryostatanordnung nach einem der vorhergehenden Ansprüche, **dadurch gekennzeichnet, dass** mindestens ein Aufhängerohr (9) des Kryobehälters (1), der mit dem Halsrohr (2) wärmeleitend verbunden ist, zusätzlich mit einer weiteren Leitung (16) oder ausschließlich mit der weiteren Leitung (16) verbunden ist, die mit dem Halsrohr (2) thermisch kontaktiert ist und in den Kryobehälter (1) mündet, wobei in der weiteren Leitung (16) eine Absperrarmatur und/oder eine Pumpe eingefügt sein kann.

10. Kryostatanordnung nach einem der der Ansprüche 1 bis 7, **dadurch gekennzeichnet, dass** der Kryobehälter (1) über mindestens eine Fluidleitung, die durch den Außenmantel der Kryostatanordnung geführt ist, mit dem sich auf Umgebungstemperatur befindenden Ende des Halsrohrs (2) verbunden ist, wobei der Außenmantel, der mindestens eine Kryobehälter (1), das Halsrohr (2) und die mindestens eine Fluidleitung einen evakuierten Raum begrenzen, und wobei in die Fluidleitung im Bereich zwischen dem Außenmantel und dem Halsrohr ein Schnellschlussventil (10) und eine Absperrarmatur integriert sind.

11. Kryostatanordnung nach einem der vorhergehenden Ansprüche, **dadurch gekennzeichnet, dass** der Kryokühler (1) ein Pulsrohrkühler oder ein Gifford-McMahon Kühler mit mindestens zwei Kältestufen ist, wobei an einer Kältestufe des Kaltkopfs (3) des Kryokühlers (1) eine Temperatur von 77 K oder eine tiefere Temperatur und gleichzeitig an einer anderen Kältestufe flüssiges Helium bei einer Temperatur von 4,2 K oder bei einer tieferen Temperatur erzeugt werden kann.

12. Kryostatanordnung nach Anspruch 11, **dadurch gekennzeichnet, dass** mindestens eine Kältestufe des Kaltkopfs (3) des Kryokühlers (1), welche nicht die kälteste Kältestufe ist, an einem Strahlungsschild (20) oder einem weiteren Kryobehälter (1), welcher nicht der kälteste Kryobehälter ist, thermisch angekoppelt ist.

13. Kryostatanordnung nach Anspruch 12, **dadurch gekennzeichnet, dass** die thermische Ankopplung der mindestens einen Kältestufe an den Strahlungsschild oder den weiteren Kryobehälter eine flexible und/oder starre Festkörperverbindung ist, welche durch die Halsrohrwand geführt ist.

14. Kryostatanordnung nach Anspruch 13, **dadurch gekennzeichnet, dass** zur thermischen Ankopplung der mindestens einen Kältestufe an den Strahlungsschild (20) oder den weiteren Kryobehälter (1) ein Gasspalt (23) zwischen der mindestens einen Kältestufe des Kaltkopfs (1) des Kryokühlers und der mit der Halsrohrwand verbundenen Festkörperverbindung vorgesehen ist.

15. Kryostatanordnung nach einem der Ansprüche 1 bis 10 **dadurch gekennzeichnet, dass** der Kryokühler (1) ein Pulsrohrkühler oder ein Gifford-McMahon Kühler mit einer Kältestufe ist, wobei an der Kältestufe eine Temperatur von 77 K oder eine tiefere Temperatur erzeugt werden kann.

16. Kryostatanordnung nach einem der vorhergehenden Ansprüche, **dadurch gekennzeichnet, dass** die Rohre (13) des Kaltkopfes des Kryokühlers (1) im Bereich zumindest einer Kältestufe zumindest teilweise mit einer Wärmeisolation (24) umgeben sind.

17. Kryostatanordnung nach einem der vorhergehenden Ansprüche, **dadurch gekennzeichnet, dass** in mindestens einem der Kryobehälter (1) eine elektrische Heizung (12) vorgesehen ist.

18. Kryostatanordnung nach einem der vorhergehenden Ansprüche, **dadurch gekennzeichnet, dass** im oder am Halsrohr (2) eine elektrische Heizung (17) vorgesehen ist, und/oder an mindestens einer Kältestufe des Kryokühlers (1) eine elektrische Heizung vorgesehen ist, welche sich in Kontakt mit dieser Kältestufe befindet.

19. Kryostatanordnung nach einem der Ansprüche 2 bis 18, **dadurch gekennzeichnet, dass** die supraleitende Magnetanordnung Teil einer Apparatur zur Magnetresonanz-Spektroskopie, insbesondere Magnetresonanzbildgebung (MRI) oder Kernmagnetresonanz-Spektroskopie (NMR), ist.

## Claims

1. Cryostat configuration for keeping cryogenic fluids in at least one cryocontainer (1'), comprising an outer shell, a radiation shield (20), and a neck tube (2') containing a cold head (3) of a cryocooler, wherein at least the coldest cold stage of the cold head of the cryocooler is disposed in a contact-free manner relative to the neck tube (2') and the cryocontainer (1'), and wherein the neck tube (2') contains a cryogenic fluid, **characterized in that** the neck tube (2) is disposed between the outer shell of the cryostat configuration and at least one cryocontainer (1) and/or the radiation shield (20), that the neck tube (2) is closed in a gas-tight manner at the end facing the cryocontainer (1) and/or the radiation shield (20), that the neck tube (2) is coupled to one of the cryocontainers (1) and/or the radiation shield (20) which is disposed between the cryocontainers (1) or between a cryocontainer (1) and the outer shell, via a connection having a good thermal conductivity, and that the neck tube (2) comprises a fill-in device at the end which is at ambient temperature, for filling a cryogenic fluid into the neck tube (2).

2. Cryostat configuration according to claim 1, **characterized in that** a superconducting magnet configuration is disposed in one of the cryocontainers (1).

3. Cryostat configuration according to any one of the preceding claims, **characterized in that** the cryogenic fluid in the neck tube (2) and in the cryocontainer (1) is the same.

4. Cryostat configuration according to claim 1 or 2, **characterized in that** the neck tube (2) and the cryocontainer (1) contain different cryogenic fluids.

5. Cryostat configuration according to any one of the preceding claims, **characterized in that** the closed end of the neck tube (2) directly contacts the cryocontainer (1) or the radiation shield (20).

6. Cryostat configuration according to any one of the claims 1 through 4, **characterized in that** the closed end of the neck tube (2) does not directly contact the cryocontainer (1) or the radiation shield (20) but is connected thereto via rigid or flexible elements (6) having a good thermal conductivity.

7. Cryostat configuration according to any one of the preceding claims, **characterized in that** the neck tube (2) is connected to an external cryogenic fluid reservoir (19) via the fill-in device.

8. Cryostat configuration according to any one of the preceding claims, **characterized in that** the cryocontainer (1) is suspended at at least one suspension tube (9) which is connected to the outer shell of the cryostat configuration, wherein the outer shell, the cryocontainer(s) (1), the at least one suspension tube (9) and the neck tube (2) define an evacuated space, and wherein the neck tube (2) is connected to at least one suspension tube (9) of the cryocontainer (1) via a connecting line (8) which can be shut-off and which comprises an integrated rapid-action valve (10).

9. Cryostat configuration according to any one of the preceding claims, **characterized in that** at least one suspension tube (9) of the cryocontainer (1), which is connected to the neck tube (2) in a heat-conducting manner, is also connected to an additional line (16) or exclusively connected to the additional line (16), which is in thermal contact with the neck tube (2) and which terminates in the cryocontainer (1), wherein a shut-off device and/or a pump may be inserted in the additional line (16).

10. Cryostat configuration according to any one of the claims 1 through 7, **characterized in that** the cryocontainer (1) is connected to the end of the neck tube (2) which is at ambient temperature, via at least one fluid line which is guided through the outer shell of the cryostat configuration, wherein the outer shell, the at least one cryocontainer (1), the neck tube (2) and the at least one fluid line define an evacuated space, and wherein a rapid-action valve (10) and a shut-off device are integrated in the fluid line in the region between the outer shell and the neck tube.

11. Cryostat configuration according to any one of the preceding claims, **characterized in that** the cryocooler (1) is a pulse tube cooler or a Gifford-McMahon cooler having at least two cold stages, wherein a temperature of 77 K or less can be generated at a cold stage of the cold head (3) of the cryocooler (1), and at the same time liquid helium of a temperature of 4.2 K or less can be generated at another cold stage.

12. Cryostat configuration according to claim 11, **characterized in that** at least one cold stage of the cryocooler (1) cold head (3) which is not the coldest cold stage is thermally coupled to a radiation shield (20) or a further cryocontainer (1) which is not the coldest cryocontainer.

13. Cryostat configuration according to claim 12, **characterized in that** thermal coupling between the at least one cold stage and the radiation shield or the further cryocontainer is realized via a flexible and/or rigid solid connection which penetrates the neck tube wall.

14. Cryostat configuration according to claim 13, **characterized in that** a gas gap (23) is provided between the at least one cold stage of the cryocooler cold head (1) and the solid connection connected to the neck tube wall for thermal coupling of the at least one cold stage to the radiation shield (20) or the further cryocontainer (1).

15. Cryostat configuration according to any one of the claims 1 through 10, **characterized in that** the cryocooler (1) is a pulse tube cooler or a Gifford-McMahon cooler comprising one cold stage, wherein a temperature of 77 K or less can be generated at the cold stage.

16. Cryostat configuration according to any one of the preceding claims, **characterized in that** the tubes (13) of the cold head of the cryocooler (1) are at least partially surrounded by thermal insulation (24) in the region of at least one cold stage.

17. Cryostat configuration according to any one of the preceding claims, **characterized in that** an electric heating means (12) is provided in at least one of the cryocontainers (1).

18. Cryostat configuration according to any one of the preceding claims, **characterized in that** an electric heating means (17) is provided in or at the neck tube (2) and/or an electric heating means is provided at at least one cold stage of the cryocooler (1) and is in contact therewith.

19. Cryostat configuration according to any one of the claims 2 through 18, **characterized in that** the superconducting magnet configuration is part of an apparatus for magnetic resonance spectroscopy, in particular, magnetic resonance imaging (MRI) or nuclear magnetic resonance spectroscopy (NMR).

## Revendications

1. Arrangement de cryostat pour conserver des fluides cryogéniques dans au moins un cryoconteneur (1') avec une enveloppe extérieure, un écran anti-rayonnement (20) et un tube à collet (2') dans lequel est logée une tête froide (3) d'un cryoréfrigérateur, au moins l'étage de réfrigération le plus froid de la tête froide du cryoréfrigérateur étant disposé sans contact par rapport au tube à collet (2') et au cryoconteneur (1'), et un fluide cryogénique se trouvant dans le tube à collet (2'),
**caractérisé en ce**
**que** le tube à collet (2) est disposé entre l'enveloppe extérieure de l'arrangement de cryostat et au moins un cryoconteneur (1) et/ou l'écran anti-rayonnement (20), que le tube à collet (2) est fermé de manière étanche aux gaz à l'extrémité tournée vers l'écran anti-rayonnement (20), que le tube à collet (2) est couplé par une liaison bonne conductrice de la chaleur à un des cryoconteneurs (1) et/ou à l'écran anti-rayonnement (20) qui est disposé entre les cryoconteneurs (1) ou entre un cryoconteneur (1) et l'enveloppe extérieure, et que le tube à collet (2) présente à l'extrémité qui se trouve a température ambiante un dispositif de remplissage pour verser un fluide cryogénique dans le tube à collet (2).

2. Arrangement de cryostat selon la revendication 1, **caractérisé en ce qu'**un arrangement magnétique supraconducteur est disposé dans un des cryoconteneurs (1).

3. Arrangement de cryostat selon une des revendications précédentes, **caractérisé en ce que** le même fluide cryogénique se trouve dans le tube à collet (2) et dans le cryoconteneur (1).

4. Arrangement de cryostat selon la revendication 1 ou 2, **caractérisé en ce que** des fluides cryogéniques différents se trouvent dans le tube à collet (2) et dans le cryoconteneur (1).

5. Arrangement de cryostat selon une des revendications précédentes, **caractérisé en ce que** l'extrémité fermée du tube à collet (2) est en contact direct avec le cryoconteneur (1) ou l'écran anti-rayonnement (20).

6. Arrangement de cryostat selon une des revendications 1 à 4, **caractérisé en ce que** l'extrémité fermée du tube à collet (2) n'est pas en contact direct avec le cryoconteneur (1) ou l'écran anti-rayonnement (20), mais reliée à celui-ci par des éléments (6) rigides ou flexibles, bons conducteurs de la chaleur.

7. Arrangement de cryostat selon une des revendications précédentes, **caractérisé en ce que** le tube à collet (2) est relié par le dispositif de remplissage à un réservoir externe de fluide cryogénique.

8. Arrangement de cryostat selon une des revendications précédentes, **caractérisé en ce que** le cryoconteneur (1) est suspendu à au moins un tube de suspension (9) qui est relié à l'enveloppe extérieure de l'arrangement de cryostat, l'enveloppe extérieure, le ou les cryoconteneur(s) (1), ledit au moins un tube de suspension (9) et le tube à collet (2) limitant un volume mis au vide, et le tube à collet (2) étant relié à au moins un tube de suspension (9) du cryoconteneur (1) par une conduite de raccordement (8) pouvant être fermée, dans laquelle est intégrée une vanne à fermeture rapide (10).

9. Arrangement de cryostat selon une des revendications précédentes, **caractérisé en ce qu'**au moins un tube de suspension (9) du cryoconteneur (1), qui est relié de manière conductrice de la chaleur au tube à collet (2), est reliée en plus à une autre conduite (16), ou exclusivement à l'autre conduite (16), qui est en contact thermique avec le tube à collet (2) et débouche dans le cryoconteneur (1), un organe de fermeture et/ou une pompe pouvant être inséré(e) dans l'autre conduite (16).

10. Arrangement de cryostat selon une des revendications 1 à 7, **caractérisé en ce que** le cryoconteneur (1) est relié par au moins une conduite de fluide, qui passe à travers l'enveloppe extérieure de l'arrangement de cryostat, à l'extrémité du tube à collet (2) se trouvant à température ambiante, l'enveloppe extérieure, ledit au moins un cryoconteneur (1), le tube à collet (2) et ladite au moins une conduite de fluide limitant un volume mis au vide, et une vanne à fermeture rapide (10) et un organe de fermeture étant intégrés dans la conduite de fluide dans la zone comprise entre l'enveloppe extérieure et le tube à collet.

11. Arrangement de cryostat selon une des revendications précédentes, **caractérisé en ce que** le cryoréfrigérate (1) est un réfrigérateur à tube pulsé ou un réfrigérateur Gifford-McMahon à au moins deux étages de réfrigération, une température de 77 K ou une température inférieure pouvant être produite à un étage de réfrigération de la tête froide (3) du cryoréfrigérateur (1) et, en même temps, de l'hélium liquide à une temperature de 4,2 K ou à une température inférieure pouvant être produit à un autre étage de réfrigération.

12. Arrangement de cryostat selon la revendication 11, **caractérisé en ce qu'**au moins un étage de réfrigération de la tête froide (3) du cryoréfrigérateur (1), qui n'est pas l'étage de réfrigération le plus froid, est couplé thermiquement à un écran anti-rayonnement (20) ou à un autre cryoconteneur (1) qui n'est pas le cryoconteneur le plus froid.

13. Arrangement de cryostat selon la revendication 12, **caractérisé en ce que** le couplage thermique dudit au moins un étage de réfrigération avec l'écran anti-rayonnement ou l'autre cryoconteneur est une liaison solide flexible et/ou rigide qui passe à travers la paroi du tube à collet.

14. Arrangement de cryostat selon la revendication 13, **caractérisé en ce que** pour le couplage thermique dudit au moins un étage de réfrigération avec l'écran anti-rayonnement (20) ou l'autre cryoconteneur (1), il est prévu une lame de gaz (23) entre ledit au moins un étage de réfrigération de la tête froide (1) du cryoréfrigérateur et la liaison solide reliée à la paroi du tube à collet.

15. Arrangement de cryostat selon une des revendications 1 à 10, **caractérisé en ce que** le cryoréfrigérateur (1) est un réfrigérateur à tube pulsé ou un réfrigérateur Gifford-McMahon à un étage de réfrigération, une température de 77 K ou une température inférieure pouvant être produite à l'étage de réfrigération.

16. Arrangement de cryostat selon une des revendications précédentes, **caractérisé en ce que** les tubes (13) de la tête froide du cryoréfrigérateur (1) sont entourés au moins partiellement d'une isolation thermique (24) au niveau d'au moins un étage de réfrigération.

17. Arrangement de cryostat selon une des revendications précédentes, **caractérisé en ce qu'**il est prévu un chauffage électrique (12) dans au moins un des cryoconteneurs (1).

18. Arrangement de cryostat selon une des revendications précédentes, **caractérisé en ce qu'**il est prévu un chauffage électrique (17) dans ou sur le tube à collet (2) et/ou, sur au moins un étage de réfrigération du cryoréfrigérateur (1), un chauffage électrique qui est en contact avec cet étage de réfrigération.

19. Arrangement de cryostat selon une des revendications 2 à 18, **caractérisé en ce que** l'arrangement magnétique supraconducteur fait partie d'un appareil de spectroscopie par résonance magnétique, en particulier d'imagerie par résonance magnétique (IRM) ou de spectroscopie par résonance magnétique nucléaire (RMN).
